# EUROPEAN PATENT APPLICATION

(11) **EP 2 017 886 A1**
(43) Date of publication of application: **21.01.2009**
(21) Application number: 07742965.2
(22) Date of filing: 08.05.2007
(51) Int. Cl.: H01L 23/15, B22D 19/00, B24C 1/00, B26F 3/00, C04B 35/565, C04B 41/88, C04B 41/91, C22C 29/06, H01L 23/12, H01L 23/36, C22C 1/10

(54) **ALUMINUM-SILICON CARBIDE COMPOSITE BODY AND METHOD FOR PROCESSING THE SAME**

(30) Priority: 09.05.2006 JP 2006130044
(71) Applicant: Denki Kagaku Kogyo Kabushiki Kaisha, Tokyo 103-8338 (JP)
(72) Inventor: IWAMOTO, Goh, Omuta-shi Fukuoka 836-8510 (JP); HIROTSURU, Hideki, Omuta-shi Fukuoka 836-8510 (JP)
(74) Representative: Hartz, Nikolai
(86) International application number: PCT/JP2007/059530
(87) International publication number: WO 2007/129715

(57) **Abstract**

An aluminum-silicon carbide composite suitable as e.g. a base plate for power module is provided.

An aluminum-silicon carbide composite comprising a flat plate-shaped silicon carbide porous body infiltrated with a metal containing aluminum as the main component, aluminum layers made of a material containing aluminum as the main component formed on both principal planes of the porous body, wherein the aluminum-silicon carbide composite has side faces formed by abrasive jet fabrication and the side faces do not have the aluminum layers made of a metal containing aluminum as the main component.

## Description

### TECHNICAL FIELD

The present invention relates to an aluminum-silicon carbide composite suitable for e.g. a base plate for power module, and to a process for producing such a composite.

### BACKGROUND ART

In recent years, along with progress of high density integration and downsizing of semiconductor chips, heat generation amount simply increases, and efficient heat radiation of circuit substrates to be used for such semiconductor chips is required. For this reason, for e.g. a substrate for power module, a ceramic circuit substrate is used, which is constituted by a ceramic substrate such as an aluminum nitride substrate or a silicon nitride substrate having high insulation property and high thermal conductivity, and a metal circuit made of copper or aluminum formed on a front surface of the ceramic substrate, and a metal heat radiation plate made of copper or aluminum formed on a rear surface of the ceramic substrate.

A typical heat radiation structure of conventional power module is constituted by a ceramic circuit substrate and a base plate soldered to the circuit substrate, wherein the base plate is usually made of copper or aluminum. However, in this structure, for example, when a heat load is applied, there occurs such a problem that the difference between thermal expansion coefficients of the base plate and the ceramic circuit substrate causes a crack in the solder layer, which prevents sufficient heat radiation, and causes malfunction or destruction of a semiconductor on the circuit.

To solve such a problem, an aluminum alloy-silicon carbide composite is proposed as a base plate which has a thermal expansion coefficient close to that of ceramic circuit substrate (refer to Patent Document 1).
Patent Document 1: JP-A-3-509860

In recent years, base plate shape for power module becomes more complicated and in order to produce a predetermined shape, a machining such as grinding using a tool such as diamond is required. Further, along with downsizing of power module itself, in order to achieve precision fabrication of a base plate and to prevent dimension change due to adhesion of solder to a side surface of the base plate at a time of assembly, a structure to which solder hardly adhered is desired. In order to prevent adhesion of solder, it is effective to expose silicon carbide that has low wettability with solder, but since an aluminum-silicon carbide composite is a hard material, such a method has a demerit that it takes a long fabrication time in a case of machining the composite until silicon carbide is exposed, which lowers productivity and increases cost.

In addition, there has been a problem that residual stress is formed in the aluminum-silicon carbide composite at the time of machining, which causes significant change of bow at a time of annealing treatment after the machining. To cope with this problem, such a method has been used, in which a preform is inserted in a metal frame having a shape close to final shape and infiltration is carried out in advance, to minimize machining amount. However, when infiltration is carried out by using a metal frame having a final shape, there has been such problems that a step of separating the composite from the metal frame after the infiltration becomes troublesome, chipping occurs at the time of separation, or the variation of final dimension of the aluminum-silicon carbide composite after the separation becomes large.

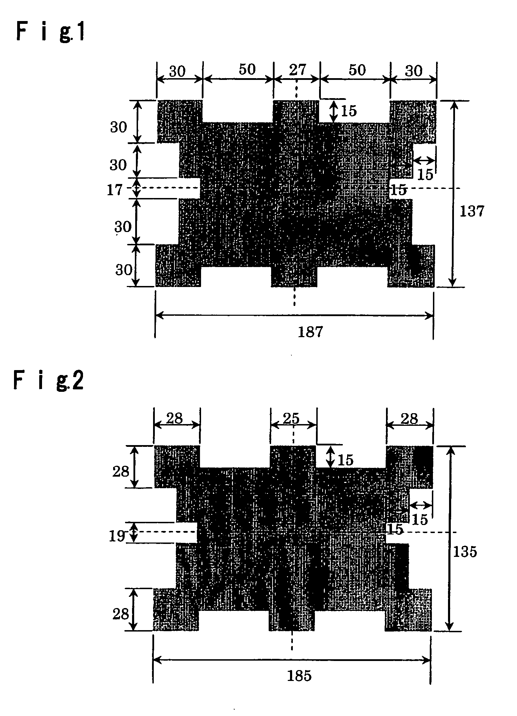

Further, there has been a problem that when a composite has a complicated outer peripheral shape, and the composite is produced by using a mold frame of final shape, stress is concentrated on corner portions of the composite to cause a crack at a cooling step after producing the composite. There has also a method of producing a composite having an outer peripheral portion made of an aluminum alloy shown e.g. in Fig. 1, and machining the outer peripheral portion. However, also in this case, the difference in thermal expansion between the aluminum alloy and the aluminum-silicon carbide composite causes to lose the balance of stress at the time of fabrication, to form a crack. For this reason, in order to produce a base plate having a complicated shape, it has been necessary to prepare a flat plate-shaped aluminum-silicon carbide composite larger than the product shape, sufficiently remove internal residual stress by e.g. an annealing treatment, and to carry out a grinding treatment of the outer peripheral shape by using a tool made of diamond, and accordingly, there has been a problem that the production cost become extremely high.

### DISCLOSURE OF THE INVENTION

### PROBLEMS TO BE SOLVED BY THE INVENTION

The present invention has been made considering the above circumstances, and it is an object of the present invention to provide an aluminum-silicon carbide composite suitable as e.g. a base plate for power module, and its production process.

### MEANS OF SOLVING THE PROBLEMS

Namely, the present invention has the following gists.
(1) An aluminum-silicon carbide composite comprising a flat plate-shaped silicon carbide porous body infiltrated with a metal containing aluminum as the main component, aluminum layers made of a material containing aluminum as the main component formed on both principal planes of the porous body, wherein the aluminum-silicon carbide composite has side faces formed by abrasive jet fabrication and the side faces do not have the aluminum layers made of a metal containing aluminum as the main component.
(2) The aluminum-silicon carbide composite according to the above (1), wherein the metal containing aluminum as the main component contains from 7 to 25 mass% of silicon.
(3) The aluminum-silicon carbide composite according to the above (1) or (2), wherein the metal containing aluminum as the main component contains from 0.5 to 0.9 mass% of magnesium.
(4) A base plate for power module comprising the aluminum-silicon carbide composite as defined in any one of the above (1) to (3).
(5) A process for producing the aluminum-silicon carbide composite as defined in any one of the above (1) to (4), which comprises a step of infiltrating a metal containing aluminum as the main component into the silicon carbide porous body by using a squeeze casting method of high pressure infiltration method.
(6) The process for producing the aluminum-silicon carbide composite according to the above (5), which further comprises an annealing treatment at from 400 to 550°C for 10 minutes after the metal containing aluminum as the main component is infiltrated.
(7) A method for fabricating an aluminum-silicon carbide composite comprising a flat plate-shaped silicon carbide porous body infiltrated with a metal containing aluminum as the main component, the method comprising fabricating side faces and holes of the aluminum-silicon carbide composite by a abrasive jet process, forming aluminum layers made of a material containing aluminum as the main component on both principal planes of the aluminum-silicon carbide composite and not forming the aluminum layers made of a metal containing aluminum as the main component on side faces of the composite.
(8) The method of fabricating an aluminum-silicon carbide composite according to the above (7), wherein the pressurized water pressure of the abrasive jet process is from 200 to 300 MPa and the fabrication speed is at most 100 mm/min.

### EFFECTS OF THE INVENTION

The aluminum-silicon carbide composite of the present invention has no aluminum layer made of an aluminum alloy on side surfaces of the composite, whereby the composite has a merit that its dimension change due to adhesion of solder at a time of assembly is little, and thus, it can be easily assembled. Further, by machining the aluminum-silicon carbide composite portion by abrasive jet process, no thermal stress is generated by the machining, generation of crack due to release of the stress at the fabrication process can be suppressed, whereby such a process produces merits that complicated shape can be produced easily and fabrication time can be reduced.

For these reasons, the aluminum-silicon carbide composite of the present invention is suitable as e.g. a base plate for power module for mounting various types of present and future semiconductor components required to have high reliability.

### BRIEF DESCRIPTION OF THE DRAWINGS

Fig. 1: A schematic plan view of an aluminum-silicon carbide composite processed in Examples 1 to 3 and Comparative Example 1.
Fig. 2: A schematic plan view of a SiC preform employed in Comparative Example 2.

### BEST MODE FOR CARRYING OUT THE INVENTION

With respect to the process for producing the aluminum-silicon carbide composite employed in the present invention, there is no particular problem so long as it employs an infiltration method of infiltrating an aluminum alloy into a silicon carbide porous body, and such an infiltration method may be a method of infiltrating under a normal pressure, or a squeeze casting method such as a molten metal infiltration method or a die cast method, but for the viewpoint of e.g. productivity, a molten metal infiltration method is preferred.

The process for producing the porous silicon carbide molded body (hereinafter it is also referred to as SiC preform) is not particularly limited, and it can be produced by a known method. For example, it can be obtained by mixing a silicon carbide powder (hereinafter referred to as SiC powder) with e.g. a silica or an alumina as a binder, molding them and sintering them preferably at at least 800°C.

As the SiC powder to be employed in the present invention, a powder produced by a known production method such as a gas phase method or an Acheson method may be employed.

Further, the SiC powder is not particularly limited in particle size distribution, and the powder may be used as it is or used after its particle size is adjusted. For example, a mixed powder is employed, which contains preferably from 40 to 80 mass% of a SiC coarse powder having an average particle size of at least 40 µm and preferably from 60 to 20 mass% of SiC fine powder having an average particle size of at most 15 µm.

The method of molding the SiC powder of the present invention into a predetermined shape, is not particularly limited, and it may be a press molding, an extrusion molding or a casting molding, and a shape-retention binder may be used in combination as the case requires.

There is not particular limitation in drying method, and each of the molded products of SiC powder is dried alone or the molded products of SiC powder are dried by using spacers made of carbon and having the same shape as preform, whereby change of bow shape by drying can be prevented.

Further, also in a sintering step, by carrying out the treatment in the same manner as the drying step, change of the shape due to the change of internal texture can be prevented.

Then, the molded product of SiC powder is degreased and sintered. The relative density of the SiC preform after the sintering is preferably within a range of from 55 to 75%. The strength of SiC preform is preferably at least 3 MPa, more preferably at least 5 MPa in terms of bending strength to prevent crack at times of handling or infiltration. The sintering temperature is at least 800°C, more preferably at least 900°C, whereby a preform having a bending strength of at least 3 MPa can be obtained regardless of the atmosphere at the time of sintering. However, when the sintering is carried out at a temperature more than 1,100°C under an oxidation atmosphere, oxidation of SiC is promoted and the thermal conductivity of the aluminum-silicon carbide composite may decrease. For this reason, the sintering is preferably carried out at a temperature of 1,100°C or lower when the atmosphere is an oxidation atmosphere. The sintering time may be appropriately determined according to conditions such as the size of SiC preform, the amount of the raw material put in a sintering furnace, the sintering atmosphere etc.

In the present invention, the size of SiC preform needs to be larger than its final dimension. If the preform dimension is smaller than the final dimension, when the aluminum-silicon carbide composite after infiltration is machined by abrasive jet cutter, the aluminum alloy layer may remain on one or more side faces of the composite.

Then, SiC preforms are stacked. Heretofore, SiC preforms have been stacked and accommodated in a preliminary determined mold frame to constitute a single block so that the SiC preforms have a predetermined size when an aluminum alloy is infiltrated into these preforms. On the other hand, in the present invention, it is not necessary to use such a mold frame at the time of infiltration since the preforms are machined by using abrasive jet cutter after the infiltration, and such a process is preferred in terms of productivity. When a mold frame is used in the present invention, a mold frame larger than the final dimension needs to be employed.

After the block constituted by the pile of SiC preforms is preliminary heated at about from 500 to 650°C, one or at least two such blocks are disposed in a high pressure container, molten aluminum alloy is poured as quickly as possible to prevent temperature drop of the blocks, and they are pressurized at a pressure of preferably at least 30 MPa, more preferably at least 35 MPa, to infiltrate the aluminum alloy into the pores of the SiC preforms. Thereafter, by cutting the block infiltrated with the alloy, aluminum-silicon carbide composites each having entire surface provided with an aluminum alloy layer are obtained. Here, in order to remove residual stress at the time of infiltration, an annealing treatment may be carried out. Such an annealing treatment has also an effect of reinforcing joining the aluminum alloy layer with the silicon carbide composite.

In the aluminum-silicon carbide composite of the present invention, the aluminum alloy preferably has a low melting point to sufficiently penetrate into pores of the preform at the time of infiltration. As such an aluminum alloy, an aluminum alloy containing from 7 to 25 mass%, preferably from 9 to 15 mass%, of silicon may be mentioned. Further, the aluminum alloy preferably contains magnesium to reinforce bonding of the silicon carbide particles with the metal portion, and the content of magnesium is preferably from 0.5 to 0.9 mass%, more preferably from 0.7 to 0.9 mass%. Metal components in the aluminum alloy other than aluminum, silicon and magnesium is not particularly restricted so long as they do not extremely change the characteristics, and for example, the alloy may contain e.g. copper in some cases.

The annealing treatment for removing residual stress caused by the infiltration of aluminum alloy, is preferably carried out at from 400 to 550°C, preferably from 500 to 550°C, for at least 10 minutes, preferably at least 30 minutes. If the annealing temperature is less than 400°C, residual stress in the composite is not sufficiently released, and the residual stress may cause significant change of bow in the subsequent steps. On the other hand, if the annealing temperature exceeds 550°C, the aluminum alloy infiltrated may melt. If the annealing time is less than 10 minutes, even if the annealing temperature is from 400 to 450°C, the residual stress in the composite is not sufficiently released, and the bow may significantly change in the subsequent steps.

Important characteristics of the aluminum-silicon carbide composite are thermal conductivity and thermal expansion coefficient. When the SiC content in the aluminum-silicon carbide composite is high, the thermal conductivity is high and the thermal expansion coefficient is low and such a characteristics are preferred, but when its content is high, the aluminum alloy may not be sufficiently infiltrated.

The aluminum-silicon carbide composite of the present invention has aluminum layers made of an aluminum alloy on both principal planes of the composite. These aluminum layers are necessary for securing plating adhesiveness at a time of applying plating treatment. The thickness of these aluminum layers is preferably from 10 to 150 µm, more preferably at most 100 µm in the average thickness. If the average thickness is less than 10 µm, the aluminum-silicon carbide composite is partially exposed in subsequent surface treatment such as a pretreatment for plating, and plating is not formed or plating adhesiveness is deteriorated in such a portion in some cases. On the other hand, if the average thickness exceeds 150 µm, the thermal expansion coefficient of the base plate itself obtained becomes too high, and the reliability of the joining portion may decrease.

Further, the aluminum-silicon carbide composite of the present invention has a characteristic that it does not have aluminum layers on side faces. When there is no aluminum layer on side faces, in contrast from a case where aluminum layers are remaining on side faces, a solder adhered to the side faces after the plating can be easily removed, dimension change due to adhesion of solder can be significantly lowers, and thus, such a composite can be easily assembled into a downsized power module.

It is preferred that all side faces of the aluminum-silicon carbide composite have no aluminum layer, but in the present invention, it is not necessary that all side faces have no aluminum layer but it is sufficient that a part of side faces have no aluminum layer since such a structure provides a certain effect. In the present invention, preferably at least 20%, more preferably at least 30%, of the area of side faces have no aluminum layer.

The abrasive jet process employed for fabricating the aluminum-silicon carbide composite into final dimension, employs abrasive particles of e.g. garnet as an abrasive. The average particle size of the abrasive particles is from 80 to 150 µm, preferably from 100 to 130 µm. The pressure (water pressure) and the cutting speed at the time of cutting is appropriately determined according to the thickness of the aluminum-silicon carbide composite. For example, when the thickness of the aluminum-silicon carbide composite is from 3 to 5 mm, the water pressure for cutting is preferably from 200 to 300 MPa, more preferably from 200 to 250 MPa, the cutting speed is usually at most 100 mm/min, more preferably at most 80 mm/min. If the pressure is less than 200 MPa or the cutting speed exceeds 100 mm/min, cutting defects or dimension difference between fabrication surface and a rear surface increases, which may cause defective fabrication in some cases.

In order to suppress the dimension difference between the fabrication surface and the rear surface within a predetermined level at the time of abrasive jet process, it is effective to reduce an abrasive nozzle size of an abrasive jet cutter or to carry out cutting while the nozzle head is tilted in relation to a work. In a case of fabricating an aluminum-silicon carbide composite by abrasive jet process under the conditions that the thickness of the aluminum-silicon carbide composite is 5 mm, the water pressure is 200 MPa and the machining speed is 100 mm/min, in order to suppress the dimension difference between both principal planes to be within 0.6 mm, it is effective to make the abrasive nozzle size to be at most 1.0 mm or to tilt a nozzle head by from 3 to 20° to the outside from a direction perpendicular to a work.

The aluminum-silicon carbide composite according to the present invention does not have aluminum alloy layers on the side faces, whereby the composite has a merit that its dimension change due to adhesion of solder at a time of soldering is little, and thus, it can be easily assembled.

Further, by fabricating it by abrasive jet process, it has merits that it can be easily fabricated into a complicated shape and that its fabrication time can be significantly reduced.

For these reasons, the composite is suitable as e.g. a base plate for power module for mounting various types of current and future semiconductor components required to have high reliability.

### EXAMPLES

Now, the present invention will be described in more detail with reference to Examples, but the present invention is not construed as limited to these Examples.

### EXAMPLE 1

70 g of SiC powder A (manufactured by Pacific Rundum Co., Ltd.: NG-220, average particle size: 60 µm), 30 g of SiC powder B (manufactured by Yakushima Denko Co., Ltd.: GC-1000F, average particle size: 10 µm) and 10 g of silica sol (manufactured by Nissan Chemical Industries, Ltd.: Snowtex) were weighed, they were blended for 30 minutes by a stirring mixer, and press-molded under a pressure of 10 MPa into a flat plate shape of 190 mm x 140 mm x 5.0 mm. The molded product obtained was sintered in an atmospheric air at 900°C for 2 hours to obtain a SiC preform having a relative density of 65%.

The SiC preform obtained was sandwiched between SUS plates whose both surfaces are coated with carbon to be integrated and they were preliminary heated at 600°C in an electric furnace. Subsequently, they were accommodated in a press mold having an inner diameter of 300 mm that had been preliminary heated, molten aluminum alloy containing 12 mass% of silicon and 0.5 mass% of magnesium was poured and they were pressurized at 100 MPa for 20 minutes so that the aluminum alloy was infiltrated into the SiC preform. They were cooled to a room temperature, and cut by using a wet type band sow so that the thickness of the aluminum layers made of an aluminum alloy formed on the outer periphery of the aluminum-silicon carbide composite became at most 10 mm, the sandwiching SUS plates were removed, and the composite was subjected to an annealing treatment at 530°C for 3 hours to remove residual stress formed at the time of infiltration, to obtain an aluminum-silicon carbide composite.

Then, the aluminum-silicon carbide composite was fabricated into a shape shown in Fig. 1. By using a abrasive jet cutter (manufactured by Sugino Machine Limited, Abrasive Jet Cutter NC), and under the conditions that the pressure was 250 MPa, the cutting speed was 50 mm/min, the abrasive nozzle size was 1.2 mm, a nozzle head was fixed and garnet having a particle size of 100 µm was used as an abrasive, the aluminum-silicon carbide composite was fabricated so that aluminum layers made of an aluminum alloy on side faces were completely removed.

### EXAMPLE 2

In the same manner as Example 1, an aluminum-silicon carbide composite was prepared, and it was subjected to abrasive jet fabrication under the same conditions of Example 1 except that the abrasive nozzle size was 0.8 mm.

### EXAMPLE 3

An aluminum-silicon carbide composite was prepared in the same manner as Example 1, and it was subjected to abrasive jet fabrication under the same conditions as Example 1 except that a nozzle head was tilted by 10° to the outside in relation to a work for fabrication.

### COMPARATIVE EXAMPLE 1

The aluminum-silicon carbide composite of Example 1 was employed, and it was fabricated into the shape of Fig. 1 by machining (HX400iF, manufactured by Kitamura Machinery Co., Ltd.).

### COMPARATIVE EXAMPLE 2

An aluminum-silicon carbide composite was prepared in the same manner as Example 1 except that a flat plate-shaped SiC preform having dimensions (unit: mm) shown in Fig. 2 and a thickness of 5.0 mm was employed, and it was subjected to abrasive jet fabrication into the shape of Fig. 1 in the same manner as Example 1. On side faces of the aluminum-silicon carbide composite of this Comparative Example, aluminum alloy layers of 1 mm thick were present.

### EXAMPLE 4

10 Each of aluminum-silicon carbide composites of Examples 1 to 3 and Comparative Examples 1 and 2 were prepared, and an average time required for fabrication of composite was measured. Further, the size difference between front and rear planes after the fabrication were measured and their average was calculated.

Each of the aluminum-silicon carbide composites of Examples 1 to 3 and Comparative Examples 1 and 2 fabricated was subjected to an electroless nickel plating treatment, to form a plating layer of 5 µm thick on the aluminum layer made of an aluminum alloy. Subsequently, a commercial aluminum nitride circuit substrate (size: 120 x 80 mm, manufactured by Denki Kagaku Kogyo Kabushiki Kaisha) was joined with an aluminum-silicon carbide composite subjected to a nickel plating treatment by using an eutectic solder containing a flux having the same size as the aluminum nitride circuit substrate and a thickness of 200 µm, and after they were bonded, the number of aluminum-silicon carbide composites which have side faces to which solder was adhered was measured. Table 1 shows the results.

**TABLE 1**

| | Front-rear dimension difference | Fabrication time per a composite | Adhesion of solder |
|---|---|---|---|
| | mm | min | Number of composite |
| Ex. 1 | 0.73 | 23 | 0 |
| Ex. 2 | 0.52 | 21 | 0 |
| Ex. 3 | 0.46 | 30 | 0 |
| Comp. Ex. 1 | 0.18 | 1260 | 0 |
| Comp. Ex. 2 | 0.05 | 18 | 3 |

### INDUSTRIAL APPLICABILITY

The aluminum-silicon carbide composite of the present invention that is fabricated by abrasive jet cutter, has merits that forming of cracks caused by release of stress formed at a time of fabrication is suppressed, and that a complicated shape can be produced easily, and the composite produces an effect that the fabrication time is reduced, and accordingly, the composite is usable as e.g. a base plate for power module for mounting semiconductor components required to have high reliability.

The entire disclosure of Japanese Patent Application No. 2006-130044 filed on May 9, 2006 including specification, claims, drawings and summary is incorporated herein by reference in its entirety.

## Claims

1. An aluminum-silicon carbide composite comprising a flat plate-shaped silicon carbide porous body infiltrated with a metal containing aluminum as the main component, aluminum layers made of a material containing aluminum as the main component formed on both principal planes of the porous body, wherein the aluminum-silicon carbide composite has side faces formed by abrasive jet fabrication and the side faces do not have the aluminum layers made of a metal containing aluminum as the main component.

2. The aluminum-silicon carbide composite according to Claim 1, wherein the metal containing aluminum as the main component contains from 7 to 25 mass% of silicon.

3. The aluminum-silicon carbide composite according to Claim 1 or 2, wherein the metal containing aluminum as the main component contains from 0.5 to 0.9 mass% of magnesium.

4. A base plate for power module comprising the aluminum-silicon carbide composite as defined in any one of Claims 1 to 3.

5. A process for producing the aluminum-silicon carbide composite as defined in any one of Claims 1 to 4, which comprises a step of infiltrating a metal containing aluminum as the main component into the silicon carbide porous body by using a squeeze casting method of high pressure infiltration method.

6. The process for producing the aluminum-silicon carbide composite according to Claim 5, which further comprises an annealing treatment at from 400 to 550°C for 10 minutes after the metal containing aluminum as the main component is infiltrated.

7. A method for fabricating an aluminum-silicon carbide composite comprising a flat plate-shaped silicon carbide porous body infiltrated with a metal containing aluminum as the main component, the method comprising fabricating side faces and holes of the aluminum-silicon carbide composite by a abrasive jet process, forming aluminum layers made of a material containing aluminum as the main component on both principal planes of the aluminum-silicon carbide composite and not forming the aluminum layers made of a metal containing aluminum as the main component on side faces of the composite.

8. The method of fabricating an aluminum-silicon carbide composite according to Claim 7, wherein the pressurized water pressure of the abrasive jet process is from 200 to 300 MPa and the fabrication speed is at most 100 mm/min.
